# EUROPÄISCHE PATENTSCHRIFT

(11) **EP 0 595 069 B1**
(45) Veröffentlichungstag und Bekanntmachung des Hinweises auf die Patenterteilung: **06.08.1997**
(21) Anmeldenummer: 93116009.7
(22) Anmeldetag: 04.10.1993
(51) Int. Cl.: H03K 19/013, H03K 19/086

(54) **Schaltstufe in Stromschaltertechnik**
Current switching stage
Etage commutateur de courant

(30) Priorität: 28.10.1992 DE 4236430
(43) Veröffentlichungstag der Anmeldung: 04.05.1994
(73) Patentinhaber: SIEMENS AKTIENGESELLSCHAFT, 80333 München (DE)
(72) Erfinder: Wilhelm, Wilhelm, Dr., D-81477 München (DE); Herrle, Jürgen, Dipl.-Ing., D-85051 Ingolstadt (DE)

(56) Entgegenhaltungen:
- EP-A- 0 294 163
- WO-A-85/04774
- US-A- 5 079 448
- RCA Technical Note No. 949, Mailed December 31, 1973
- A.H. Seidman, "Integrated Circuits Applications Handbook", John Wiley and Sons, Seiten 311-313

## Beschreibung

Die Erfindung betrifft eine Schaltstufe mit einer Differenzverstärkeranordnung, mit einem ersten Bipolartransistor, der in Emitterfolgerschaltung mit einem Ausgang der Differenzverstärkeranordnung verbunden ist und dessen Emitter mit einem Ausgang der Schaltstufe verbunden ist, mit einer Stromquelle, die zwischen den Ausgang der Schaltstufe und einen Anschluß für ein Versorgungspotential geschaltet ist, mit einem weiteren Bipolartransistor in Emitterfolgerschaltung, der mit dem Ausgang der Differenzverstärkeranordnung verbunden ist, wobei der Emitter des ersten Bipolartransistors mit einem ersten Eingang einer Vergleichseinrichtung und der Emitter des weiteren Bipolartransistors mit einem zweiten Eingang der Vergleichseinrichtung verbunden ist, wobei die Stromquelle eine steuerbare Stromquelle mit einem Steuereingang ist, der mit einem Ausgang der Vergleichseinrichtung verbunden ist, und wobei die steuerbare Stromquelle durch die Vergleichseinrichtung derart gesteuert wird, daß ein hoher Strom von der Stromquelle eingeprägt wird, wenn das Potential des Emitters des ersten Bipolartransistors höher ist als das Potential des Emitters des weiteren Bipolartransistors und daß anderenfalls ein niedriger Strom eingeprägt wird.

Eine solche Schaltstufe ist aus der EP 0 367 612 A2 bekannt und in Figur 1 durch ein Prinzipschaltbild dargestellt. Bei der bekannten Schaltstufe ist die Vergleichseinrichtung durch einen Differenzverstärker gegeben, der mit zwei Transistoren gebildet ist, deren Emitter über eine Stromquelle mit Bezugspotential verbunden sind. Die steuerbare Stromquelle ist zweistufig aufgebaut.

Aus der EP 0 438 953 A1 ist ebenfalls eine Schaltstufe mit einem Differenzverstärker, zwei Bipolartransistoren und einer Vergleichsschaltung, die eine Stromquelle ansteuert und durch eine Stromspiegelschaltung gegeben ist, bekannt. Bei dieser Schaltstufe werden allerdings die beiden Bipolartransistoren von Differenzverstärkerausgängen unterschiedlicher Polarität angesteuert.

Auch die JP 2-231 814 (A) aus Patent Abstracts of Japan, 1990, Vol. 14, Nr. 541, E-1007, offenbart eine Schaltstufe mit einem Differenzverstärker, zwei Bipolartransistoren und einer Vergleichsschaltung, die eine Stromquelle ansteuert. Die dortige Vergleichsschaltung ist mit einem zweistufen Stromschalter gebildet. Auch dort werden die Bipolartransistoren jeweils von einem verschiedenen Ausgang des Differenzverstärkers angesteuert.

Aus der WO 85/04774 ist eine Schaltstufe nach dem Oberbegriff des Anspruchs 1 bekannt.

Es ist die Aufgabe der Erfindung, weitere Schaltungsanordnungen für eine Vergleichseinrichtung anzugeben.

Diese Aufgabe wird mit den Merkmalen des kennzeichnenden Teils des Anspruchs 1 gelöst.

Eine erfindungsgemäße Schaltstufe hat den Vorteil, daß der von der steuerbaren Stromquelle eingeprägte Strom nur dann hoch ist, wenn er zum Umladen der Lastkapazitat benötigt wird. Sonst ist der Strom niedrig. Die Stromquelle kann derart dimensioniert werden, daß die negative Schaltflanke gemäß den Geschwindigkeitsanforderungen genügend steil ist, wobei trotzdem die Verlustleistung niedrig bleibt.

Die Ausführung der Vergleichseinrichtung als Stromspiegelschaltung hat den Vorteil, daß der Augangspegel weitgehend unbeeinflußt von Schwankungen der Versorgungsspannung ist.

Die steuerbare Stromquelle kann als Bipolartransistor ausgeführt werden. Mittels mindestens einer Diode, die zwischen den Emitter und den Anschluß für das Versorgungspotential geschaltet ist, wird die Basis-Emitter-Spannung des Bipolartransistors reduziert. Dies hat den Vorteil, daß der Bipolartransistor für eine geringere Spannungsbelastung dimensioniert werden kann.

Es ist vorteilhaft, zwischen den Anschluß für das Versorgungspotential und den entsprechenden Versorgungsanschlüssen der Vergleichseinrichtung mindestens eine Diode zu schalten, da dadurch die durch die Vergleichseinrichtung fließende Ströme geringer bzw. bei gleichen Strömen die Widerstände kleiner dimensioniert werden können.

Die Erfindung wird im folgenden anhand der in der Figur dargestellten Ausführungsbeispiele näher erläutert. Es zeigen
- Figur 1: ein Prinzipschaltbild einer bekannten Schaltstufe,
- Figur 2: eine erste Ausführungsform des Ausgangsteils einer erfindungsgemäßen Schaltstufe und
- Figur 3: eine zweite Ausführungsform des Ausgangsteils einer erfindungsgemäßen Schaltstufe.

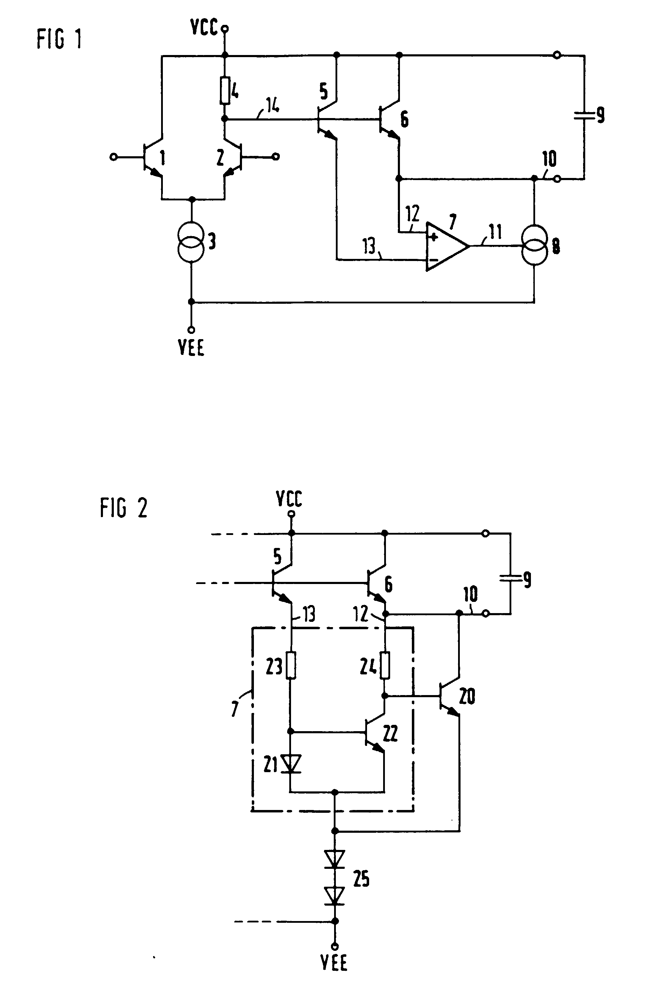

Die Schaltstufe der Figur 1 enthält eine eine Logikfunktion ausführende Differenzverstärkeranordnung, der eine Ausgangsstufe zum Treiben der Lastkapazitäten nachgeschaltet ist. Die Differenzverstärkeranordnung enthält zwei emittergekoppelte Bipolartransistoren 1, 2, deren Emitter über eine Stromquelle 3 mit einem Anschluß für ein negatives Versorgungspotential VEE verbunden sind. Die Kollektoren der Transistoren 1, 2 sind an einen Anschluß für ein positives Versorgungspotential VCC gelegt. In den Kollektorkreis des Transistors 2 ist ein Arbeitswiderstand 4 geschaltet. Die Basis des Transistors 1 wird von einem Eingangssignal gesteuert, die Basis des Transistors 2 von einem Referenzsignal. Der Ausgang 14 der Differenzverstärkeranordnung ist der kollektorseitige Anschluß des Widerstands 4. Dieser ist mit den Basisanschlüssen zweier Bipolartransistoren 5, 6 verbunden. Die Transistoren 5, 6 sind bezüglich des Ausgangs der Differenzverstärkeranordnung in Emitterfolgerschaltung geschaltet. Der Emitter des Bipolartransistors 6 ist mit einem Ausgang 10 der Schaltstufe verbunden. Mit dem Ausgang 10 verbundene weitere Schaltungen und Verbindungsleitungen wirken im wesentlichen als kapazitive Last 9. Der Ausgang 10 ist über eine steuerbare Stromquelle 8 mit dem Potential VEE verbunden. Die steuerbare Stromquelle 8 weist einen Steuereingang 11 auf, der mit dem Ausgang einer Vergleichseinrichtung 7 verbunden ist. Die Eingänge 12, 13 der Vergleichseinrichtung 7 sind mit dem belasteten Emitter des Transistors 6 bzw. dem unbelasteten Emitter des Transistors 5 verbunden. Die Vergleichseinrichtung 7 ist derart aufgebaut, daß sie nur dann an ihrem Ausgang ein Signal erzeugt, mittels dem in der Stromquelle 8 ein hoher Strom einstellbar ist, wenn der Emitter des Transistors 5 auf niedrigerem Potential liegt als der Emitter des Transistors 6. In den sonstigen Betriebszuständen, wenn also die Emitterpotentiale der Transistoren 5, 6 etwa gleich sind oder Emitter des Transistors 5 ein höheres Potential aufweist als der Emitter des Transistors 6, erzeugt die Vergleichseinrichtung 7 ein Signal, mittels dem in der Stromquelle 8 ein niedriger Strom einstellbar ist. Im folgenden wird die Funktionsweise der Schaltstufe bei einem Umschaltvorgang von einem H- auf einen L-Pegel am Ausgang 10 betrachtet: Das Emitterpotential des Transistors 5 folgt weitgehend unverzögert dem Kollektorpotential des Transistors 2, da der Emitter des Transistors 5 nicht durch die Ausgangslast kapazitiv belastet ist. Das Emitterpotential des Transistors 6 folgt aufgrund der Kapazität 9 vorerst zeitverzögert dem Kollektorpotential des Transistors 2. Durch diese Potentialdifferenz an den Eingängen der Vergleichseinrichtung 7 wird an deren Ausgang ein Signal erzeugt, durch das die Stromquelle 8 derart gesteuert wird, daß ein hoher Strom fließt. Dadurch wird die Kapazität 9 aufgeladen, wodurch das Emitterpotential des Transistors 6 absinkt und die Potentialdifferenz an den Eingängen der Vergleichseinrichtung 7 abnimmt. Daraufhin wird der Strom der Stromquelle 8 wieder niedrig gesteuert. Beim umgekehrten Schaltvorgang, also bei einem Übergang von einem L- zu einem H-Pegel ist die Potentialdifferenz an den Eingängen der Vergleichseinrichtung 7 derart, daß der Strom der Stromquelle 8 niedrig eingestellt ist. Der Strom zum Entladen der Lastkapazität 9 fließt hier über die Kollektor-Emitter-Strecke des Transistors 6.

Diese Schaltstufe hat den Vorteil, daß der Strom der Stromquelle 8 nur dann hoch ist, wenn der zum Laden der Kapazität 9 benötigte Strom über die Stromquelle 8 zum Anschluß für das Versorgungspotential VEE fließt, also beim Umschalten von H nach L. Damit kann bei vertretbarer Verlustleistung die negative Flanke relativ steil eingestellt werden. Bei einer solchen Schaltungsstufe wird eine hohe Arbeitsgeschwindigkeit bei niedriger Verlustleistung ermöglicht.

Eine erfindungsgemäße Ausführungsform der Vergleichseinrichtung 7 und der Stromquelle 8 sind in der Figur 2 gezeigt. Die Vergleichseinrichtung 7 enthält eine Stromspiegelschaltung mit einem Eingangszweig und einem Ausgangszweig: Diese sind jeweils an einem ersten Anschluß mit dem Emitter des Transistors 5 bzw. dem Emitter des Transistors 6 verbunden.

Beide Zweige sind an einem zweiten Anschluß gekoppelt und an das Versorgungspotential VEE gelegt. Der Eingangszweig enthält eine Diode 21, die der Basis-Emitter-Strecke eines Bipolartransistors 22 parallel geschaltet ist. Ein Widerstand 23 ist zwischen der Diode 21 und dem Emitter des Transistors 5 angeordnet. Ein weiterer Widerstand 24 ist zwischen den Kollektor des Transistors 22 und den Emitter des Transistors 6 geschaltet. Der Kollektor des Transistors dient als Ausgang der Vergleichseinrichtung 7. Er ist mit dem Steuereingang der Stromquelle 8 verbunden, die als Bipolartransistor 20 ausgeführt ist. Der Kollektor des Bipolartransistors 20 ist mit dem Ausgang 10 der Schaltstufe, der Emitter mit dem Versorgungspotential VEE verbunden.

Die gekoppelten zweiten Anschlüsse der Ein- und Ausgangszweige der Stromspiegelschaltung sind mit dem Emitter des Stromquellentransistors 20 gekoppelt, wobei sie über zwei Dioden 25 mit dem Anschluß für das Versorgungspotential VEE verbunden sind. Die Dioden 25 bewirken, daß der Transistor 20 und die Elemente der Vergleichseinrichtung 7 für eine geringere Arbeitsspannung ausgelegt werden können.

Bei dem für die Wirkungsweise der Vergleichseinrichtung 7 interessierenden Umschaltvorgang von H nach L sinkt das Emitterpotential des unbelasteten Transistors 5 relativ schnell ab. Der Spannungsabfall am Widerstand 23 wird verringert, so daß der Strom im Eingangszweig 21, 23 der Stromspiegelschaltung abnimmt. Der niedrigere Strom - gespiegelt in den Ausgangszweig 22, 24 - erzeugt am Widerstand 24 einen geringeren Stromabfall. Außerdem liegt das Emitterpotential des belasteten Emitters des Transistors 6 noch weitgehend auf H. Dies hat zur Folge, daß das Basispotential des Transistors 20 hoch ist und der Transistor 20 leitet. Die Kapazität 90 wird nun über den Transistor 20 geladen. Das Emitterpotential des Transistors 6 sinkt auf L, wodurch bei entsprechender Dimensionierung der Bauelemente der Transistor 20 hochohmig wird.

Bei Schwankungen des Versorgungspotentials VEE bleibt das Verhältnis der Ströme des Eingangszweiges und des Ausgangszweiges der Stromspiegelschaltung gleich. Versorgungsspannungsschwankungen werden nicht an den Ausgang 10 weitergegeben.

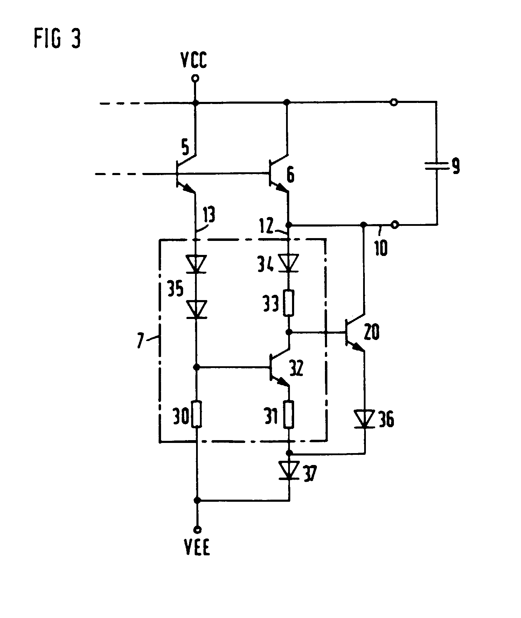

Die Figur 3 enthält eine weitere erfindungsgemäße Ausführungsform für die Vergleichseinrichtung 7. Die gesteuerte Stromquelle ist als Bipolartransistor 20 realisiert, dessen Emitter über zwei Dioden 36, 37 mit dem Anschluß für das Versorgungspotential VEE verbunden ist. Die Vergleichseinrichtung 7 weist einen ersten Strompfad auf, der einen Widerstand 30 enthält, der mit einem Anschluß mit dem Versorgungspotential VEE und mit einem anderen Anschluß über zwei Dioden 35 mit dem Emitter des Transistors 5 verbunden ist. Ein zweiter Strompfad enthält die Kollektor-Emitter-Strecke eines Bipolartransistors 32, dessen Basis mit dem anderen Anschluß des Widerstandes 30 verbunden ist. Der Emitter des Bipolartransistors 32 ist über einen Widerstand 31 an das Versorgungspotential VEE gelegt. Der Widerstand 31 kann-wie in der Figur 3 dargestellt - über die Diode 37 mit dem Anschluß für das Versorgungspotential VEE verbunden sein. Der Kollektor des Bipolartransistors 30 dient als Ausgang der Vergleichseinrichtung 7. Er ist über einen Widerstand 33 und eine Diode 34 mit dem Emitter des Transistors 6 verbunden.

Bei dem interessierenden Umschaltvorgang von H nach L wird die Spannung am Widerstand 30 verringert, wodurch der Widerstand der Kollektor-Emitter-Strecke des Transistors 32 zunimmt und der Strom verringert wird. Dies hat zur Folge, daß der Spannungsabfall am Widerstand 33 geringer wird und somit das Kollektorpotential des Transistors 32 ansteigt. Der Stromquellentransistor 20 leitet dann stark. Dadurch wird die Kapazität 9 aufgeladen. Mit Absinken des Potentials am Ausgang 10 wird der Stromquellentransistor 20 hochohmig.

Die Dioden 34,...,37 dienen der Potentialverschiebung, so daß die Bauelemente für geringere Arbeitsspannungen diemensioniert werden können. Es ist prinzipiell möglich, die Diode 34 und eine der Dioden 35 zu entfernen. Andererseits können zwischen den Widerständen 30, 31 und dem Anschluß für das Versorgungspotential VEE weitere Dioden eingefügt werden.

## Patentansprüche

1. Schaltstufe
mit einer Differenzverstärkeranordnung,
mit einem ersten Bipolartransistor (6), der in Emitterfolgerschaltung mit einem Ausgang (14) der Differenzverstärkeranordnung verbunden ist und dessen Emitter mit einem Ausgang (10) der Schaltstufe verbunden ist,
mit einer Stromquelle (8), die zwischen den Ausgang (10) der Schaltstufe und einen Anschluß für ein Versorgungspotential (VEE) geschaltet ist,
mit einem weiteren Bipolartransistor (5) in Emitterfolgerschaltung, der mit dem Ausgang (14) der Differenzverstärkeranordnung verbunden ist,
wobei der Emitter des ersten Bipolartransistors (6) mit einem ersten Eingang (12) einer Vergleichereinrichtung (7) und der Emitter des weiteren Bipolartransistors (5) mit einem zweiten Eingang (13) der Vergleichseinrichtung (7) verbunden ist,
wobei die Stromquelle (8) eine steuerbare Stromquelle mit einem Steuereingang (11) ist, der mit einem Ausgang der Vergleichseinrichtung (7) verbunden ist,
und wobei die steuerbare Stromquelle (8) durch die Vergleichseinrichtung (7) derart gesteuert wird, daß ein hoher Strom von der Stromquelle (8) eingeprägt wird, wenn das Potential des Emitters des ersten Bipolartransistors (6) höher ist als das Potential des Emitters des weiteren Bipolartransistors (5) und daß anderenfalls ein niedriger Strom eingeprägt wird,
**dadurch gekennzeichnet,** daß die Vergleichseinrichtung (7) einen Bipolartransistor (32) enthält, dessen Basis und dessen Emitter über je einen Widerstand (30 bzw. 31) mit dem Anschluß für das Versorgungspotential (VEE) verbunden sind, daß die Basis des Bipolartransistors (32) mit dem zweiten Eingang (13) der Vergleichseinrichtung (7) verbunden ist, daß der Kollektor des Bipolartransistors (32) über einen Widerstand (33) mit dem ersten Eingang (12) der Vergleichseinrichtung (7) verbunden ist und daß der Kollektor des Bipolartransistors (32) mit dem Ausgang der Vergleichseinrichtung verbunden ist.

2. Schaltstufe nach Anspruch 1,
**dadurch gekennzeichnet,** daß zwischen die Basis des Bipolartransistors (32) der Vergleichseinrichtung (7) und den zweiten Eingang (13) der Vergleichseinrichtung (7) mindestens eine Diode (35) geschaltet ist.

3. Schaltstufe nach Anspruch 1,
**dadurch gekennzeichnet,** daß zwischen die Basis des Bipolartransistors (32) der Vergleichseinrichtung (7) und den zweiten Eingang (13) der Vergleichseinrichtung (7) zwei Dioden (35) geschaltet sind und daß zwischen den kollektorseitigen Widerstand (33) des Bipolartransistors (32) der Vergleichseinrichtung (7) und den ersten Eingang (12) der Vergleichseinrichtung (7) eine Diode (34) geschaltet ist.

4. Schaltstufe nach einem der Ansprüche 1 bis 3,
**dadurch gekennzeichnet,** daß zwischen den emitterseitigen Widerstand (31) des Bipolartransistors (32) der Vergleichseinrichtung (7) und den Anschluß für das Versorgungspotential (VEE) eine Diode (37) geschaltet ist.

5. Schaltstufe nach einem der Ansprüche 1 bis 4,
**dadurch gekennzeichnet,** daß die steuerbare Stromquelle (8) einen Bipolartransistor (20) enthält, dessen Kollektor mit dem Ausgang (10) der Schaltstufe und dessen Emitter mit dem Anschluß für das Versorgungspotential (VEE) verbunden ist, und daß die Basis des Bipolartransistors (20) der Steuereingang (11) der steuerbaren Stromquelle (8) ist.

6. Schaltstufe nach Anspruch 5,
**dadurch gekennzeichnet,** daß zwischen den Emitter des Bipolartransistors (20) der gesteuerten Stromquelle (8) und den Anschluß für das Versorgungspotential (VEE) mindestens eine Diode (25; 36, 37) geschaltet ist.

## Claims

1. Switching stage
having a differential amplifier arrangement,
having a first bipolar transistor (6), which is connected in an emitter follower circuit to an output (14) of the differential amplifier arrangement and whose emitter is connected to an output (10) of the switching stage,
having a current source (8), which is connected between the output (10) of the switching stage and a terminal for a supply potential (VEE),
having a further bipolar transistor (5) in an emitter follower circuit, which transistor is connected to the output (14) of the differential amplifier arrangement,
the emitter of the first bipolar transistor (6) being connected to a first input (12) of a comparator device (7) and the emitter of the further bipolar transistor (5) being connected to a second input (13) of the comparison device (7),
the current source (8) being a controllable current source with a control input (11) which is connected to an output of the comparison device (7),
and the controllable current source (8) being controlled by the comparison device (7) in such a way that a high current is impressed by the current source (8) when the potential of the emitter of the first bipolar transistor (6) is higher than the potential of the emitter of the further bipolar transistor (5), and that otherwise a low current is impressed,
characterized in that the comparison device (7) contains a bipolar transistor (32) whose base and whose emitter are connected in each case via a resistor (30 and 31, respectively) to the terminal for the supply potential (VEE), in that the base of the bipolar transistor (32) is connected to the second input (13) of the comparison device (7), in that the collector of the bipolar transistor (32) is connected via a resistor (33) to the first input (12) of the comparison device (7), and in that the collector of the bipolar transistor (32) is connected to the output of the comparison device.

2. Switching stage according to Claim 1, characterized in that at least one diode (35) is connected between the base of the bipolar transistor (32) of the comparison device (7) and the second input (13) of the comparison device (7).

3. Switching stage according to Claim 1, characterized in that two diodes (35) are connected between the base of the bipolar transistor (32) of the comparison device (7) and the second input (13) of the comparison device (7), and in that a diode (34) is connected between the collector-side resistor (33) of the bipolar transistor (32) of the comparison device (7) and the first input (12) of the comparison device (7).

4. Switching stage according to one of Claims 1 to 3, characterized in that a diode (37) is connected between the emitter-side resistor (31) of the bipolar transistor (32) of the comparison device (7) and the terminal for the supply potential (VEE).

5. Switching stage according to one of Claims 1 to 4, characterized in that the controllable current source (8) contains a bipolar transistor (20) whose collector is connected to the output (10) of the switching stage and whose emitter is connected to the terminal for the supply potential (VEE), and in that the base of the bipolar transistor (20) is the control input (11) of the controllable current source (8).

6. Switching stage according to Claim 5, characterized in that at least one diode (25; 36, 37) is connected between the emitter of the bipolar transistor (20) of the controlled current source (8) and the terminal for the supply potential (VEE).

## Revendications

1. Etage commutateur
avec un dispositif amplificateur différentiel,
avec un premier transistor bipolaire (6), qui est raccordé en montage émetteur suiveur à une sortie (14) du dispositif amplificateur différentiel et dont l'émetteur est raccordé à une sortie (10) de l'étage commutateur,
avec une source de courant (8) qui est connectée entre la sortie (10) de l'étage commutateur et une borne du potentiel d'alimentation (VEE),
avec un autre transistor bipolaire (5) en montage émetteur suiveur, qui est raccordé à la sortie (14) du dispositif amplificateur différentiel,
dans lequel l'émetteur du premier transistor bipolaire (6) est raccordé à une première entrée (12) d'un dispositif comparateur (7) et l'émetteur de l'autre transistor bipolaire (5) est raccordé à une deuxième entrée (13) du dispositif comparateur (7), la source de courant (8) étant une source de courant réglable comportant une entrée de commande (11), qui est raccordée à une sortie du dispositif comparateur (7), et dans lequel la source de courant réglable (8) est commandée par le dispositif comparateur (7) de sorte qu'un courant fort de la source de courant est appliqué, si le potentiel de l'émetteur du premier transistor bipolaire (6) est plus élevé que le potentiel de l'émetteur de l'autre transistor bipolaire (5) et que, sinon, un courant plus faible est appliqué,
caractérisé en ce que le dispositif comparateur (7) comprend un transistor bipolaire (32), dont la base et dont l'émetteur sont raccordés chacun au moyen d'une résistance (30 resp. 31) à la borne du potentiel d'alimentation (VEE), en ce que la base du transistor bipolaire (32) est raccordée à la deuxième entrée (13) du dispositif comparateur (7), en ce que le collecteur du transistor bipolaire (32) est raccordé au moyen d'une résistance (33) à la première entrée (12) du dispositif comparateur (7) et en ce que le collecteur du transistor bipolaire (32) est raccordé à la sortie du dispositif comparateur.

2. Etage commutateur selon la revendication 1, caractérisé en ce qu'entre la base du transistor bipolaire (32) du dispositif comparateur (7) et la deuxième entrée (13) du dispositif comparateur (7), au moins une diode (35) est connectée.

3. Etage commutateur selon la revendication 1, caractérisé en ce qu'entre la base du transistor bipolaire (32) du dispositif comparateur (7), et la deuxième entrée (13) du dispositif comparateur (7) deux diodes (35) sont connectées et en ce qu'entre la résistance (33), du côté du collecteur, du transistor bipolaire (32) du dispositif comparateur (7) et la première entrée (12) du dispositif comparateur (7), une diode (34) est connectée.

4. Etage commutateur selon l'une des revendications 1 à 3, caractérisé en ce qu'entre la résistance (31), du côté de l'émetteur, du transistor bipolaire (32) du dispositif comparateur (7) et la borne du potentiel d'alimentation (VEE) une diode (37) est connectée.

5. Etage commutateur selon l'une des revendications 1 à 4, caractérisé en ce que la source de courant réglable (8) comprend un transistor bipolaire (20), dont le collecteur est raccordé à la sortie (10) de l'étage commutateur et l'émetteur à la borne du potentiel d'alimentation (VEE), et en ce que la base du transistor bipolaire (20) est l'entrée de commande (11) de la source de courant réglable (8).

6. Etage commutateur selon la revendication 5, caractérisé en ce qu'entre l'émetteur du transistor bipolaire (20) de la source de courant réglée (8) et la borne du potentiel d'alimentation (VEE), au moins une diode (25 ; 36, 37) est connectée.
